# EUROPEAN PATENT APPLICATION

(11) **EP 4 608 089 A1**
(43) Date of publication of application: **27.08.2025**
(21) Application number: 25152431.0
(22) Date of filing: 17.01.2025
(51) Int. Cl.: H10D 30/66, H10D 12/00, H10D 62/10, H10D 62/13, H10D 64/00

(54) **HIGH-VOLTAGE-WITHSTANDING SUPER JUNCTION TERMINATION STRUCTURE**

(30) Priority: 26.02.2024 CN 202410210713
(71) Applicant: Chongqing Alpha and Omega Semiconductor Limited, Chongqing 400700 (CN)
(72) Inventor: TANG, Yizhou, Chongqing, 400700 (CN)
(74) Representative: Metida

(57) **Abstract**

A high-voltage-withstanding super junction termination structure includes a substrate (100). An N-type buffer layer (210), an N-type drift region (220), an oxide layer (300), and a dielectric layer (400) are sequentially disposed on the substrate (100). The N-type drift region (220) includes a transition region (610), a first terminal type region (620), and a second terminal type region (630) that are horizontally disposed in sequence. A JTE region is formed at a top portion of the first terminal type region (620). An N-doped structure is disposed on a top portion of the second terminal type region (630). The N-doped structure is connected to the P-doped JTE region (621). The N-doped structure is connected to third P-pillars (637). By providing the N-doped structure and the third P-pillars (637), an electric field peak at the P-doped JTE region (621) is reduced, so that reliability thereof is improved.

## Description

### TECHNICAL FIELD

The present disclosure relates to a field of super junction terminals, and in particular to a high-voltage-withstanding super junction termination structure.

### BACKGROUND

In order to more effectively improve a breakdown voltage, a super junction vertical double diffused metal oxide semiconductor field effect transistor (VDMOS) device is proposed in the prior art on a basis of a structure of a VDMOS device to obtain a device with high withstand voltage and low on-resistance. The super junction VDMOS device is widely used in electronic circuits in fields of consumption, industry, and automobile. In practical applications, for the super junction VDMOS device, when withstand voltage or reliability of the super junction VDMOS device does not meet requirements, it often causes failure of the super junction VDMOS device, and eventually leads to a damage of a circuit or an electrical appliance. Therefore, in a field of super junction, the withstand voltage and the reliability become main concerns. Due to a special structure of a super junction device, in theory, a terminal withstand voltage thereof is lower than a cell withstand voltage, so a breakdown point of the super junction device commonly appears in an terminal region. Therefore, solving withstand voltage and reliability problems of the super junction device mainly requires to solve the withstand voltage and reliability problems at the terminal region of the super junction device.

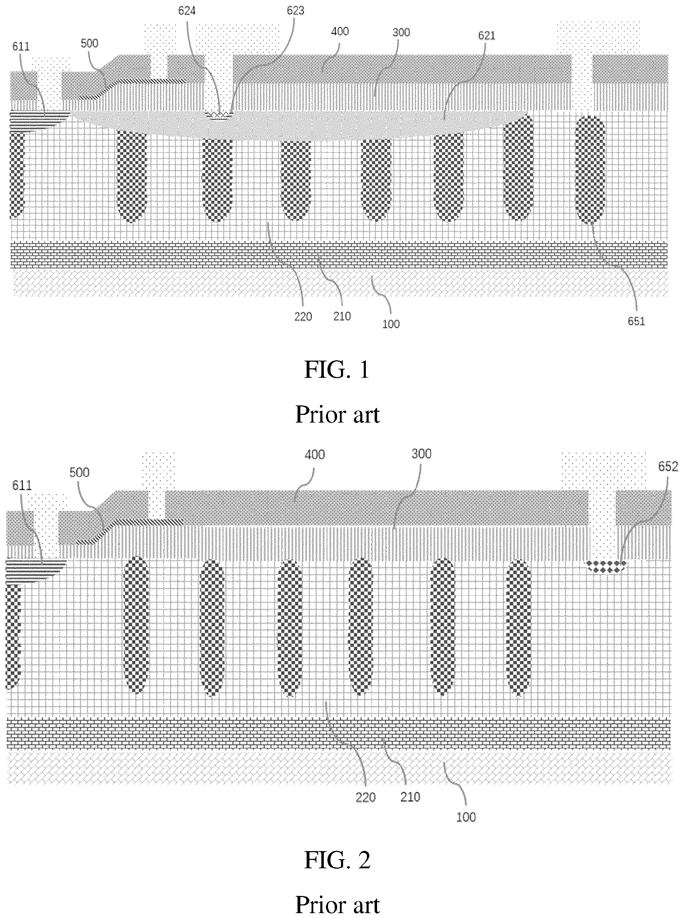

FIGS. 1-2 are schematic diagrams of two conventional mainstream super junction termination structures. The super junction termination structure shown in FIG. 1 has two major disadvantages. First, a distance between a P cutoff ring formed by a fourth P column 651 and a junction termination extension (JTE) region 621 is relatively far. Second, a field strength distribution thereof is unreasonable, and a breakdown point may appear at one end of the JTE region 621. The super junction termination structure shown in FIG. 2 has three major disadvantages. First, there is no P-pillar in a N cutoff ring region 652, so that ions there do not form a partial depletion mode, and a withstand voltage is low. Second, a distance between the N cutoff ring region 652 and a first P-doped region is relatively far, resulting in a large size of the super junction termination structure. Third, there is no JTE region 621 and field plate structure in the super junction termination structure, resulting in a high peak electric field on a surface of the super junction termination structure. Therefore, it is necessary to improve the conventional super junction termination structures.

### SUMMARY

To solve above problems, the present disclosure provides a high-voltage-withstanding super junction termination structure. The high-voltage-withstanding super junction termination structure comprises a substrate, an N-type buffer layer, an N-type drift region, an oxide layer, and a dielectric layer.

The N-type buffer layer, the N-type drift region, and the oxide layer and the dielectric layer are sequentially disposed on the substrate. The N-type drift region comprises a transition region, a first terminal type region, and a second terminal type region.

The transition region, the first terminal type region, and the second terminal type region are disposed in sequence along a horizontal direction. A first P-doped region is formed at a top portion of the transition region. A lower end of the first P-doped region is connected to at least one first P-pillar. A P-doped junction termination extension (JTE) region is formed at a top portion of the first terminal type region. A lower end of the P-doped JTE region is connected to second P-pillars. A second P-doped region is disposed in the P-doped JTE region. A third P-doped region is disposed in the second P-doped region.

A polysilicon layer is disposed at a position of the first terminal type region adjacent to the transition region, and the polysilicon layer is disposed between the oxide layer and the dielectric layer.

An N-doped structure is disposed on a top portion of the second terminal type region. The N-doped structure is connected to the P-doped JTE region. A lower end of the N-doped structure is connected to at least two third P-pillars. A height of each of the at least two third P-pillars is not greater than a minimum height of the second P-pillars in the first terminal type region.

A source metal, a gate metal, a first floating metal field plate, and a second floating metal field plate are disposed on the dielectric layer. The source metal is connected to the first P-doped region. The gate metal is connected to the polysilicon layer. The first floating metal field plate is connected to the third P-doped region. The second floating metal field plate is connected to the N-doped structure.

In the present disclosure, By providing the N-doped structure and the at least two third P-pillars in the second terminal type region, an N-cutoff ring connected to the P-doped JTE region and the at least two third P-pillars is formed, and a width of a N-depletion region having a higher doping concentration is relatively low, and a N-doped region having a lower doping concentration is relatively close to the at least two third P-pillars. Thus, an electric field peak at one end of the P-doped JTE region is reduced, making an electric field distribution more uniform and reasonable and improving reliability of the high-voltage-withstanding super junction termination structure. Moreover, an electric field valley at the one end of the P-doped JTE region is improved, and there is no breakdown point at the one end of the P-doped JTE region when the electric field peak is reduced, so that the withstand voltage of the high-voltage-withstanding super junction termination structure is improved. In addition, there is no need to ensure a distance between the N-cutoff ring and the P-doped JTE region, so a position of the N-cutoff ring is allowed to be moved forward compared to a conventional super junction termination structure, thereby reducing a size of the high-voltage-withstanding super junction termination structure

### BRIEF DESCRIPTION OF DRAWINGS

FIG. 1 is a schematic diagram of a high-voltage-withstanding super junction termination structure in the prior art.
FIG. 2 is a schematic diagram of another high-voltage-withstanding super junction termination structure in the prior art.
FIG. 3 is a schematic diagram of a high-voltage-withstanding super junction termination structure according to one embodiment of the present disclosure.
FIG. 4 is a schematic diagram of an impact ionization rate of the high-voltage-withstanding super junction termination structure in the prior art.
FIG. 5 is a schematic diagram of an impact ionization rate of the high-voltage-withstanding super junction termination structure according to one embodiment of the present disclosure.
FIG. 6 is a schematic diagram of a comparison of electric field distributions of the high-voltage-withstanding super junction termination structure in the prior art and the high-voltage-withstanding super junction termination structure of the present disclosure.
FIG. 7 is a schematic diagram of a comparison of high-voltage-withstanding performance of the high-voltage-withstanding super junction termination structure in the prior art and the high-voltage-withstanding super junction termination structure of the present disclosure.
FIG. 8 is a schematic diagram of a second terminal type region according to a second embodiment of the present disclosure.
FIG. 9 is a schematic diagram of the second terminal type region according to a third embodiment of the present disclosure.
FIG. 10 is a schematic diagram of the second terminal type region according to a fourth embodiment of the present disclosure.
FIG. 11 is a schematic diagram of the second terminal type region according to a fifth embodiment of the present disclosure.

### DETAILED DESCRIPTION

### Embodiment 1

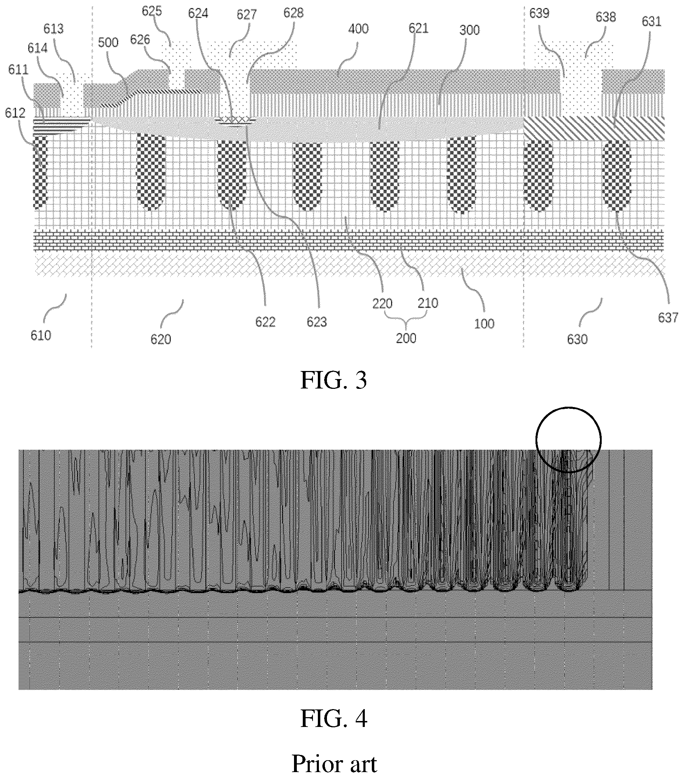

FIG. 3 is a schematic diagram of a high-voltage-withstanding super junction termination structure according to one embodiment of the present disclosure. As shown in FIG. 3, the high-voltage-withstanding super junction termination structure comprises a substrate 100. An epitaxial layer 200, an oxide layer 300, and a dielectric layer 400 are sequentially disposed on the substrate 100 from bottom to top. The epitaxial layer 200 comprises an N-type buffer layer 210 disposed on the substrate 100 and an N-type drift region 220 disposed on the N-type buffer layer 210. The N-type drift region 220 comprises a transition region 610, a first terminal type region 620, and a second terminal type region 630. The transition region 610, the first terminal type region, and the second terminal type region are disposed in sequence from left to right. That is, the first terminal type region 620 is an region between two dotted lines shown in FIG. 3, the transition region 610 is located on a left side of the first terminal type region 620, and the second terminal type region 630 is located on a right side of the first terminal type region 620.

A first P-doped region 611 is formed at a top portion of the transition region 610. A lower end of the first P-doped region 611 is connected to at least one first P-pillar 612. A source metal 613 is disposed on the dielectric layer 400, and the dielectric layer 400 is disposed above the transition region 610. A first contact hole 614 penetrating through the dielectric layer 400 and the oxide layer 300 is defined above the transition region 610. A position of the first contact hole 614 is corresponding to the source metal 613. The first P-doped region 611 is exposed through the first contact hole 614. A lower end of the source metal 613 extends into the first contact hole 614 and is connected to the first P-doped region 611.

A P-doped junction termination extension (JTE) region 621 is formed at a top portion of the first terminal type region 620. A lower end of the P-doped JTE region 621 is connected to second P-pillars 622. The lower end of the P-doped JTE region 621 is in a downwardly convex arc shape, so that heights of the second P pillars 622 are not completely the same. A second P-doped region 623 is defined in the P-doped JTE region 621, a doping concentration of the second P-doped region 623 is greater than a doping concentration of the P-doped JTE region 621, and the doping concentration of the second P-doped region 623 may be the same as a doping concentration of the first P-doped region 611.

A third P-doped region 624 is defined in the second P-doped region 623, and a doping concentration of the third P-doped region 624 is greater than the doping concentration of the second P-doped region 623. The doping concentration of the third P-doped region 624 is generally two orders of magnitude greater than the doping concentration of the second P-doped region 623. A gate metal 625 is disposed on the dielectric layer 400 and is disposed above the first terminal type region 620. A second contact hole 626 penetrating through the dielectric layer 400 is defined above the first terminal type region 620. A position of the second contact hole 626 is corresponding to the gate metal 625. A polysilicon layer 500 is exposed through the second contact hole. 626. A lower end of the gate metal 625 extends into the second contact hole 626 and is connected to the polysilicon layer500.

The polysilicon layer 500 is disposed at a position of the first terminal type region 620 adjacent to the transition region 610. The polysilicon layer 500 is disposed between the oxide layer 300 and the dielectric layer 400. A first floating metal field plate 627 is disposed on the dielectric layer 400 that is disposed above the polysilicon layer 500. A third contact hole 628 penetrating through the dielectric layer 400 and the oxide layer 300 is defined above the first terminal type region 620. A position of the first contact hole 628 is corresponding to the first floating metal field plate 627. The third P-doped region 624 is exposed through the third contact hole 628. A lower end of the first floating metal field plate 627 extends into the third contact hole 628 and is connected to the third P-doped region 624.

An N-doped structure is disposed on a top portion of the second terminal type region 630. A left end of the N-doped structure is connected to the P-doped JTE region 621. A connecting surface between the N-doped structure and the P-doped JTE region 621 is a boundary between the first terminal type region 620 and the second terminal type region 630. A lower end of the N-doped structure is connected to two third P-pillars 637. Of course, the lower end of the N-doped structure may connect to more than two third P-pillars 637. A left side surface of a leftmost third P-pillar 637 (i.e., one of the two third P-pillars 637 adjacent to the first terminal type region 620) is aligned with a boundary between the first terminal type region 620 and the second terminal type region 630. Heights of the two third P-pillars are the same. A height of each of the two third P-pillars 637 is not greater than a minimum height of the second P-pillars 622 in the first terminal type region 620. The N-doped structure and the two third P-pillars 637 optimize an electric field distribution and improve high-voltage-withstanding performance of the high-voltage-withstanding super junction termination structure.

A second floating metal field plate 638 is disposed on the dielectric layer 400 that is disposed above the second terminal type region 630. A fourth contact hole 639 penetrating through the dielectric layer 400 and the oxide layer 300 is defined above the second terminal type region 630. A position of the fourth contact hole 639 is corresponding to the second floating metal field plate 638. The N-doped structure is exposed through the fourth contact hole 639. A lower end of the second floating metal field plate 638 extends into the fourth contact hole 639 and is connected to the N-doped structure.

In the embodiment, the N-doped structure comprises a first N-doped region 631 formed by implantation. The first N-doped region 631 is strip-shaped. A left end of the first N-doped region 631 is connected to the P-doped JTE region 621. The two third P-pillars 637 are connected to a lower end of the first N-doped region 631. A doping concentration of the first N-doped region 631 is generally much greater than a doping concentration of the N-type drift region 220. For example, the doping concentration of the first N-doped region 631 may be 1e17cm⁻³-1e18cm⁻³.

In the present disclosure, by providing the first N-doped region 631 connected to the P-doped JTE region 621 and providing the two third P-pillars 637 below the first N-doped region 631 and lower than the second P-pillars 622 that are disposed in the first terminal type region 620, an N-cutoff ring connected to the P-doped JTE region 621 and the third P-pillars 637 is formed.

Since the doping concentration of the first N-doped region 631 is much greater than the doping concentration of the N-type drift region 220, an N region with a gradually increased doping concentration is formed from left to right at one end of the N-cutoff ring, which eventually leads to a low width of a high-concentration N depletion region and makes a low-concentration N-doped region closer to the leftmost third P-pillar 637 (i.e., the one of the two third P0pillars 637 adjacent to the first terminal type region 620). Thus, an electric field peak of the leftmost third P-pillar 637 (i.e., one end of the P-doped JTE region) is reduced, so a position of the electric field peak moves forward (i.e., toward the first terminal type region 620), making an electric field distribution more uniform and reasonable and improving reliability of the high-voltage-withstanding super junction termination structure. Moreover, an electric field valley of the leftmost third P-pillar 637 is improved, making an electric field and a distance integral region larger, so there is no breakdown point at the one end of the P-doped JTE region when the electric field peak is reduced. Thus, the withstand voltage of the high-voltage-withstanding super junction termination structure is improved. In addition, there is no need to ensure a distance between the N-cutoff ring and a last voltage-withstand ring, so a position of the N-cutoff ring is allowed to be moved forward compared to a conventional super junction termination structure, thereby reducing a size of the high-voltage-withstanding super junction termination structure.

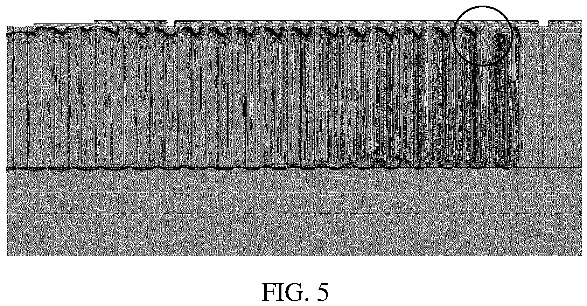

As shown in FIGS. 4 and 5, the more concentrated ionization rate curves is in FIG4 and FIGS, the greater an ionization rate is. The circles in FIGS. 4 and 5 indicate peak regions of the ionization rate curves.

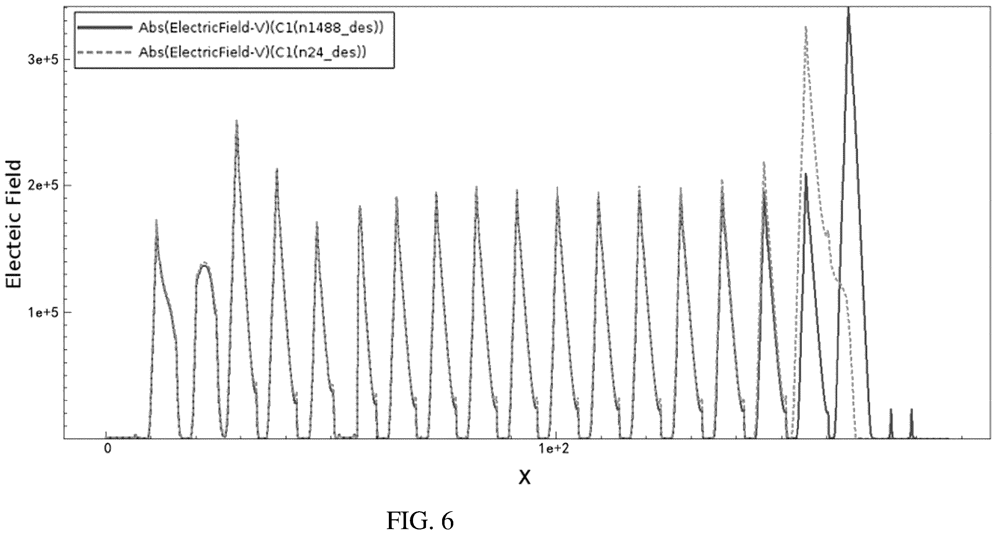

From the comparison between FIG. 4 and FIG.5, it is noted that in the high-voltage-withstanding super junction termination structure of the present disclosure, the peak point of the ionization rate (i.e., the breakdown point at the end of the P-doped JTE region 621) is moved forward to the first terminal type region 620. As shown in FIG. 6., a dotted line in FIG. 6 represents an electric field distribution of the high-voltage-withstanding super junction termination structure in the prior art, and a solid line in FIG. 6 represents an electric field distribution of the high-voltage-withstanding super junction termination structure of the embodiment. By comparison, it is noted that in the high-voltage-withstanding super junction termination structure of the embodiment, the electric field distribution is more uniform and reasonable.

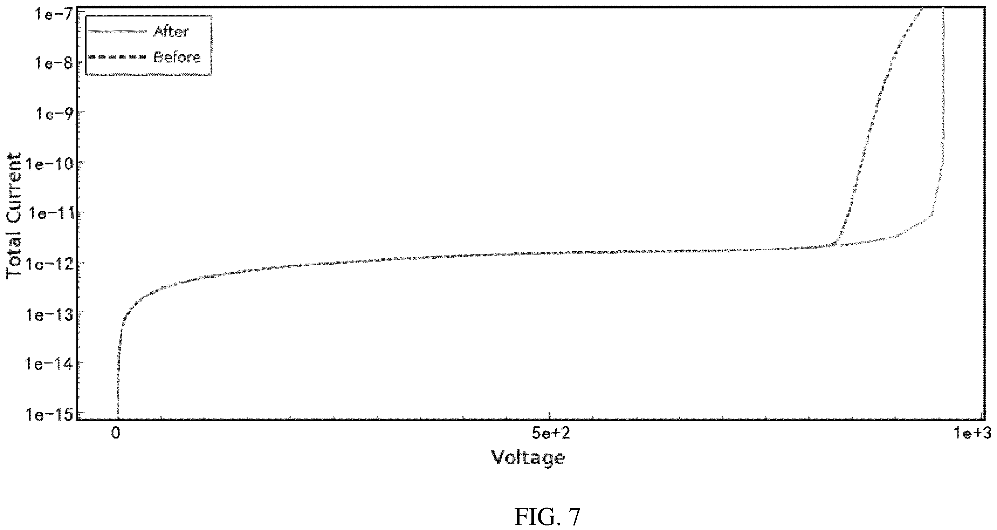

As shown in FIG. 7. the dotted line in FIG. 7 represents a voltage withstand curve of the high-voltage-withstanding super junction termination structure in the prior art, and the solid line represents a voltage withstand curve of the high-voltage-withstanding super junction termination structure of the embodiment. By comparison, it is noted that the high-voltage-withstanding performance of the high-voltage-withstanding super junction termination structure of the embodiment is improved.

### Embodiment 2

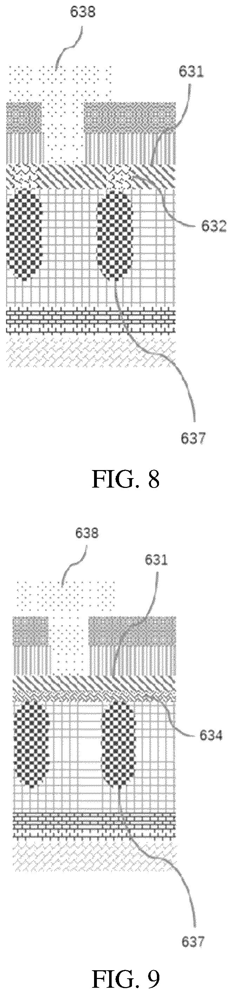

As shown in FIG. 8, FIG. 8 is a schematic diagram of the second terminal type region 630 according to the second embodiment of the present disclosure. The only difference between the embodiment and embodiment 1 is that a structure of the N-doped structure thereof is different. On the basis of embodiment 1, the N-doped structure further comprises second N-doped regions 632. Each of the second N-doped regions 632 is disposed above a corresponding third P-pillar 637. A doping concentration of the second N-doped regions 632 is less than the doping concentration of the first N-doped region 631. For example, the doping concentration of the second N-doped regions is 1e15cm⁻³-1e16cm^{-3.} A lower end of each of the second N-doped regions 632 is connected to the corresponding third P-pillar. An upper end of each of the second N-doped regions 632 is connected to the oxide layer 300.

In the embodiment, the second N-doped regions 632 have a lower doping concentration, the second N-doped regions 632 are respectively connected to the third P-pillars 637, and the second N-doped regions 632 are disposed in the first N-doped region 631, so an electric field at the leftmost third P-pillar 637 is adjusted more conveniently.

### Embodiment 3

As shown in FIG. 9, FIG. 9 is a schematic diagram of the second terminal type region 630 according to the third embodiment of the present disclosure. The only difference between the embodiment and embodiment 1 is that a structure of the N-doped structure thereof is different. The N-doped structure comprises the first N-doped region 631 and a fourth P-doped region 634 disposed below the first N-doped region 631. An upper end of each of the at least two third P-pillars is connected to the fourth P-doped region.

In the embodiment, by providing the fourth P-doped region 634 disposed below the first N-doped region 631, the electric field at the leftmost third P-pillar 637 is adjusted more conveniently.

### Embodiment 4

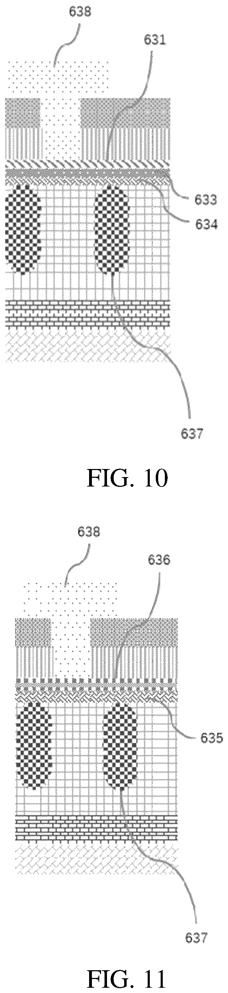

As shown in FIG. 10, FIG. 10 is a schematic diagram of the second terminal type region 630 according to the fourth embodiment of the present disclosure. The only difference between the embodiment and embodiment 3 is that the structure of the N-doped structure thereof is different. Based on embodiment 3, the N-doped structure further comprises a third N-doped region 633 disposed between the first N-doped region 631 and the fourth P-doped region 634. A doping concentration of the third N-doped region 633 is less than the doping concentration of the first N-doped region 631. For example, the doping concentration of the third N-doped region 633 may be 1e15cm⁻³-1e16cm⁻³.

In the embodiment, by providing the third N-doped region 633, an adjustment range of the electric field at the leftmost third P-pillar 637 is further increased.

### Embodiment 5

As shown in FIG. 11, FIG. 11 is a schematic diagram of the second terminal type region 630 according to the fifth embodiment of the present disclosure. The only difference between the embodiment and embodiment 1 is that the structure of the N-doped structure thereof is different. In the embodiment, the N-doped structure comprises a fifth P-doped region 635 and an N-type doped polysilicon 636. The fifth P-doped region 635 is strip-shaped. The fifth P-doped region 635 is formed by implantation in the N-type drift region 220. The N-type doped polysilicon 636 is formed by deposition on an upper end of the fifth P-doped region 635. A doping concentration of the N-type doped polysilicon 636 is greater than the doping concentration of the N-type drift region 220. For example, the doping concentration of the N-type doped polysilicon 636 is 1e17cm⁻³-1e18cm⁻³. One end of the N-type doped polysilicon 636 is connected to the P-doped JTE region 621. The upper end of each of the two third P-pillars 637 is connected to the fifth P-doped region 635.

Since the N-type doped polysilicon 636 is formed by deposition rather than by implantation, the embodiment provides another process for forming the N-doped structure, so that the N-doped structure is capable of being formed by using different processes.

## Claims

1. A high-voltage-withstanding super junction termination structure, comprising:
a substrate (100);
an N-type buffer layer (210);
an N-type drift region (220);
an oxide layer (300); and
a dielectric layer (400);
wherein the N-type buffer layer (210), the N-type drift region (220), the oxide layer (300) and the dielectric layer (400) are sequentially disposed on the substrate (100), and the N-type drift region (220) comprises a transition region (610), a first terminal type region (620), and a second terminal type region (630);
wherein the transition region (610), the first terminal type region (620), and the second terminal type region (630) are disposed in sequence along a horizontal direction, a first P-doped region (611) is formed at a top portion of the transition region (610), a lower end of the first P-doped region (611) is connected to at least one first P-pillar (612), a P-doped junction termination extension (JTE) region is formed at a top portion of the first terminal type region (620), a lower end of the P-doped JTE region (621) is connected to second P-pillars (622), a second P-doped region (623) is disposed in the P-doped JTE region (621), and a third P-doped region (624) is disposed in the second P-doped region (623);
wherein a polysilicon layer (500) is disposed at a position of the first terminal type region (620) adjacent to the transition region (610), and the polysilicon layer (500) is disposed between the oxide layer (300) and the dielectric layer (400);
wherein an N-doped structure is disposed on a top portion of the second terminal type region (630), the N-doped structure is connected to the P-doped JTE region (621), a lower end of the N-doped structure is connected to at least two third P-pillars (637), and a height of each of the at least two third P-pillars (637) is not greater than a minimum height of the second P-pillars (622) in the first terminal type region (620);
wherein a source metal (613), a gate metal (625), a first floating metal field plate (627), and a second floating metal field plate (638) are disposed on the dielectric layer (400), the source metal (613) is connected to the first P-doped region (611), the gate metal (625) is connected to the polysilicon layer (500), the first floating metal field plate (627) is connected to the third P-doped region (624), and the second floating metal field plate (638) is connected to the N-doped structure.

2. The high-voltage-withstanding super junction termination structure according to claim 1, wherein a first contact hole (614) penetrating through the dielectric layer (400) and the oxide layer (300) is defined above the transition region (610), a position of the first contact hole (614) is corresponding to the source metal (613), the first P-doped region (611) is exposed through the first contact hole (614), and a lower end of the source metal (613) extends into the first contact hole (614) and is connected to the first P-doped region (611);
wherein a second contact hole (626) penetrating through the dielectric layer (400) is defined above the first terminal type region (620), a position of the second contact hole (626) is corresponding to the gate metal (625), the polysilicon layer (500) is exposed through the second contact hole (626), and a lower end of the gate metal (625) extends into the second contact hole (626) and is connected to the polysilicon layer (500);
wherein a third contact hole (628) penetrating through the dielectric layer (400) and the oxide layer (300) is defined above the first terminal type region (620), a position of the first contact hole (614) is corresponding to the first floating metal field plate (627), the third P-doped region (624) is exposed through the third contact hole (628), and a lower end of the first floating metal field plate (627) extends into the third contact hole (628) and is connected to the third P-doped region (624);
wherein a fourth contact hole (639) penetrating through the dielectric layer (400) and the oxide layer (300) is defined above the second terminal type region (630), a position of the fourth contact hole (639) is corresponding to the second floating metal field plate (638), the N-doped structure is exposed through the fourth contact hole (639), and a lower end of the second floating metal field plate (638) extends into the fourth contact hole (639) and is connected to the N-doped structure.

3. The high-voltage-withstanding super junction termination structure according to claim 1, wherein a doping concentration of the second P-doped region (623) is greater than a doping concentration of the P-doped JTE region (621), and a doping concentration of the third P-doped region (624) is greater than the doping concentration of the second P-doped region (623).

4. The high-voltage-withstanding super junction termination structure according to claim 1, wherein an outer side surface of one of the at least two third P-pillars (637) close to the first terminal type region (620) is aligned with a boundary between the first terminal type region (620) and the second terminal type region (630).

5. The high-voltage-withstanding super junction termination structure according to any one of claims 1-4, wherein the N-doped structure comprises a first N-doped region (631) formed by implantation, a doping concentration of the first N-doped region (631) is greater than a doping concentration of the N-type drift region (220), and the first N-doped region (631) is connected to the P-doped JTE region (621).

6. The high-voltage-withstanding super junction termination structure according to claim 5, wherein the N-doped structure further comprises second N-doped regions (632); each of the second N-doped regions (632) is disposed above a corresponding third P-pillar, a doping concentration of the second N-doped regions (632) is less than the doping concentration of the first N-doped region (631), and a lower end of each of the second N-doped regions (632) is connected to the corresponding third P-pillar.

7. The high-voltage-withstanding super junction termination structure according to claim 6, wherein the doping concentration of the first N-doped region (631) is 1e17cm⁻³-1e18cm⁻³, and the doping concentration of the second N-doped regions (632) is 1e15cm⁻³-1e16cm⁻³.

8. The high-voltage-withstanding super junction termination structure according to claim 5, wherein the N-doped structure further comprises a fourth P-doped region (634) disposed below the first N-doped region (631), and an upper end of each of the at least two third P-pillars (637) is connected to the fourth P-doped region (634).

9. The high-voltage-withstanding super junction termination structure according to claim 8, wherein the N-doped structure further comprises a third N-doped region (633) disposed between the first N-doped region (631) and the fourth P-doped region (634), and a doping concentration of the third N-doped region (633) is less than the doping concentration of the first N-doped region (631).

10. The high-voltage-withstanding super junction termination structure according to any one of claims 1-4, wherein the N-doped structure comprises a fifth P-doped region (635) and an N-type doped polysilicon (636), the fifth P-doped region (635) is strip-shaped, the fifth P-doped region (635) is formed by implantation in the N-type drift region (220), and the N-type doped polysilicon (636) is formed by deposition on an upper end of the fifth P-doped region (635);
wherein a doping concentration of the N-type doped polysilicon (636) is greater than a doping concentration of the N-type drift region (220), one end of the N-type doped polysilicon (636) is connected to the P-doped JTE region (621), and an upper end of each of the at least two third P-pillars (637) is connected to the fifth P-doped region (635).
